Europäisches Patentamt

European Patent Office

Office européen des brevets

(11) Publication number: 0 409 543 A2

# EUROPEAN PATENT APPLICATION

(21) Application number: 90307772.5

(51) Int. Cl.⁵: H05K 3/00

(22) Date of filing: 16.07.90

(30) Priority: 20.07.89 JP 190068/89

(43) Date of publication of application:
23.01.91 Bulletin 91/04

(84) Designated Contracting States:
DE FR GB NL

(71) Applicant: NIPPON PAINT CO., LTD.
1-2, Oyodokita 2-chome Kita-ku
Osaka-shi(JP)

(72) Inventor: Nishijima, Kanji
1-5-21 Shima
Ibaraki-shi, Osaka-fu(JP)
Inventor: Shigeta, Junichi
6-1-213 Bessyo Nakano
Takatsuki-shi, Osaka-fu(JP)
Inventor: Kurosaki, Yoshinobu
5-1-522-612 Kouyoucho Naka,
Higashinada-ku
Kobe-shi, Hyogo-ken(JP)

(74) Representative: Whalley, Kevin et al
MARKS & CLERK 57/60 Lincoln's Inn
Fieldslds
London WC2A 3LS(GB)

(54) A method for forming a resist pattern.

(57) In a method for forming a resist pattern comprising exposing a photosensitive material which is a laminate of an insulating base plate, an electric conductive coating and a positive working photo resist coating, through a positive mask of circuit pattern placed on said photo resist, to an actinic radiation, developing the photo resist with an aqueous alkaline solution, thereby removing the exposed area and forming an etching resist, subjecting said resist to an etching with an acidic etching solution to remove the exposed conductive coating and finally removing the resist still remained on the unexposed area of the photosensitive material, an improvement which is characterized in that after said development and prior to the etching operation, the unexposed resist is further exposed to an actinic radiation. The present method is useful for giving a printed circuit board with excellent circuit pattern having no slender lines due to undesired side etching.

EP 0 409 543 A2

(d)

# A METHOD FOR FORMING A RESIST PATTERN

The present invention relates to a method for preparing a printed circuit board and more specifically, it concerns a method for preparing a printed circuit board with excellent circuit pattern having no slender lines due to undesired side etching.

With the increasing demands of getting more and more, small-size, light, weight, highly efficient and functional electronic devices, much higher density circuit pattern having the wire size of $100\mu m$ or less is often desired. Heretofore, in a preparation of a printed circuit board, use has been made of, in most cases, a dry film as an etching resist.

That is, an etching resist dry film is first laminated onto a print base plate, thus obtained laminate is exposed, developed and then subjected to etching and the remained film is finally removed off to obtain a printed circuit board. In general, such dry film used as an etching resist is of a negative type and however, there is an unavoidable limit in the extent miniaturization of circuit pattern with such dry film. In order to obtain a more high dense circuit pattern, methods have been proposed wherein photosensitive resin layers are formed on conductive coatings on base plates by an electrodeposition means and thus obtained resin layers are used as photo resist.

Such techniques are divided into two groups, i.e. one utilizing a photo curing type (negative working) photosensitive resin layer, and the other, one a photolysis type (positive working) photosensitive resin layer, as the above-mentioned photosensitive resin layer.

Since the latter is much desirable than the former in obtaining an improved resolving power, the so-called positive type photosensitive resins have been widely used in the preparation of a printed circuit board having through-holes, integrated circuit and the like and these materials and techniques have been reported in various publications including Japanese Patent Publication (unexamined) No. 207139/85; ibid 206293/86; ibid 189857/88 and the like. According to the disclosed techniques, a photo resist of positive working photosensitive resin layer is formed on an electric conductive coating on an insulating base plate by an electro-deposition means, and thus formed material is exposed through a positive mask of circuit image closely placed on :said photo resist, to an actinic radiation, thereby effecting a photo degradation of the exposed resin. Then, the exposed resin is dissolved off with an alkaline developer to form an etching resist and these treated material is subjected to an etching with an aqueous acidic solution to dissolve exposed conductive coating, e.g. copper coating. Finally, the photo resist still remained on unexposed area is removed by using an alkaline solution to obtain the desired circuit pattern.

However, in such technique of using the so-called photo-lithography in the preparation of a printed circuit board, unexposed resin is liable to be swollen in a developer at the development stage, causing the decrease in acid resistance and adhesive power of the resin to the base plate. Therefore, when the developed material is subjected to etching to dissolve the exposed conductive coating and form the desired circuit pattern, there always occur side-etching, causing the formation of slender circuit line, which often results undesired line failure.

Thus, there is a limit on the wire size of thus formed circuit line.

It is, therefore, an object of the invention to provide a method for preparing a printed circuit board having fine circuit by using a conventional photosensitive material, with the least change in the processing steps of exposure, development, etching and the like.

According to the present invention, the abovementioned object can be attained with an improvement, in a method for preparing a printed circuit board comprising exposing a photosensitive material which is a laminate of an insulating base plate, an electric conductive coating and a positive working photo resist coating, through a positive mask of circuit pattern placed on said photo resist, to an actinic radiation, developing the photo resist with an aqueous alkaline solution, thereby removing the exposed area and forming an etching resist, subjecting said resist to an etching with an acidic etching solution to remove the exposed conductive coating and finally removing the resist still remained on the unexposed area of the photosensitive material, which is characterized in that after said development and prior to the etching operation, the unexposed resist is further exposed to an actinic radiation.

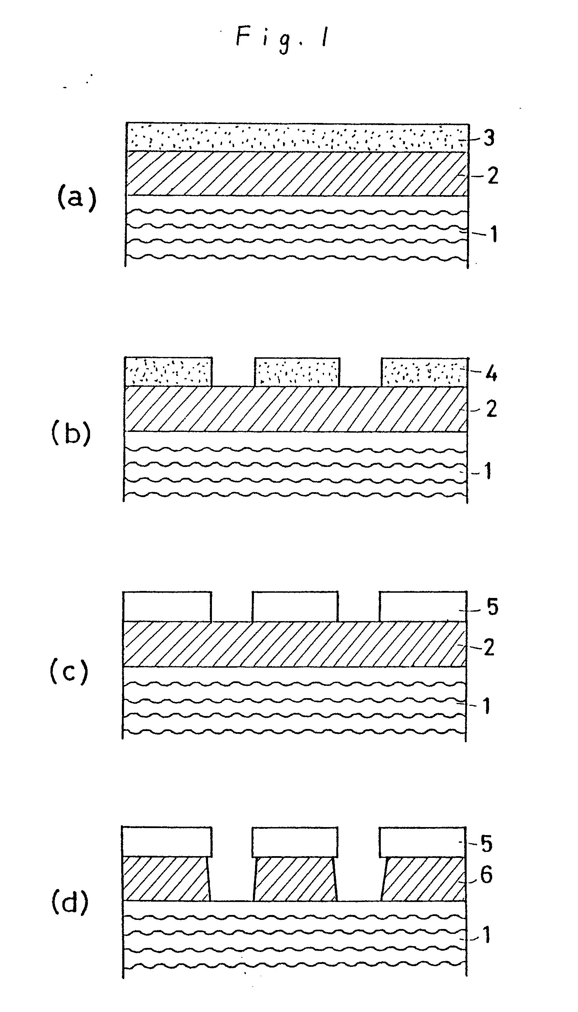

Fig. 1 (a)~(d) show the cross-section of the present photosensitive material each in different stage in the present method, in which (a) in the present photosensitive material, (b) is the photo resist obtained by an actinic radiation exposure and development step, 9c) is the photo resist again exposed to UV rays, and (d) is the resist after subjected to wet etching.

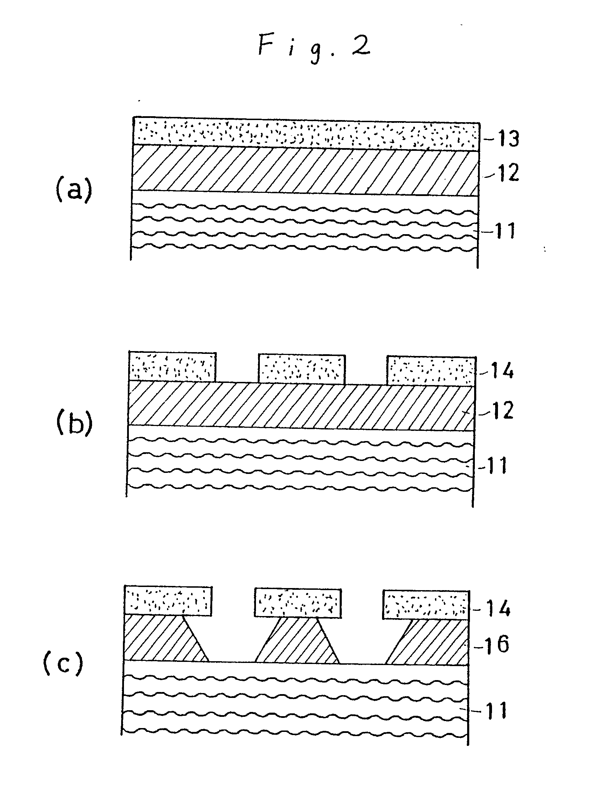

Fig. 2 (a)~(c) show the cross-section of the similar photosensitive material each in different stage in the conventional processing method, in which (a) corresponds to Fig. 1 (a), (b) corresponds to Fig. 1 (b), and (c) corresponds to Fig. 1 (d).

In this invention, heretofore proposed photosensitive materials having a positive working photo resist on a conductive coating provided on an electric insulating base plate can be advantageously used as they are.

As a positive working photo resist, any of the conventional positive type photosensitive resin composition may be successfully used, providing that when the formed coating is exposed to an actinic radiation through a circuit pattern, solubility of the exposed resin in a certain solvent is greatly increased as compared with that of the unexposed resin, and only the exposed resin is selectively removed off at the time of development with said solvent. Such photo resist coating can be applied on an electric conductive coating by using any of the conventional coating means including an electro-deposition coating, and however, in the case of a printed circuit board having through-holes, particular preference is given to the last mentioned electrodeposition coating. At that time, an electro-depositable, positive type photosensitive resin composition is advantageously used.

Examples of such resin compositions are an aqueous dispersion of such resin as having a phenolic Novolak resin structure and bearing photosensitive quinone diazide groups and ionic hydrophilic groups as disclosed in Japanese Patent Publication (unexamined) 207139/85; an aqueous dispersion of modified phenol resin having both acidic groups and quinone diazide groups as disclosed in Japanese Patent publication (unexamined) 218616/86; an aqueous dispersion of anionic or cationic acrylic resin containing quinone diazide sulfonic ester as disclosed in Japanese Patent Publication (unexamined) 206293/86; an aqueous dispersion of acrylic resin, polyester resin, epoxy resin or epoxidized polybutadiene resin having, in its side-chains or at the end portions of main chain, imino sulfonate groups as well as salt forming groups as disclosed in Japanese Patent Application No. 132756/87; and an aqueous dispersion of a reaction product of an alkali soluble type resin having acid groups, an aromatic or heterocyclic carboxylic acid having phenolic hydroxyl groups and 1,2-quinone diazide sulfonic halide as disclosed in Japanese Patent Application No. 193248/88. Of course, any of other conventional positive working photo resist materials including combination of acrylic resin and quinone diazide compound disclosed in Japanese Patent Publication (unexamined) 43451/83, may be satisfactorily used.

The desired resist pattern may be prepared by using a photosensitive material having such positive working resist coating on a conductive coating (e.g. Cu coating) placed on a printing base plate, exposing such material through a circuit pattern to an actinic radiation and subjection to a development with an alkaline developer.

In a conventional processing method, thus developed material is then subjected to an etching with an acidic etching solution coating cupric chloride or ferric chloride, thereby removing the exposed conductive coating and the remained resist is finally removed off to obtain a printed circuit board.

However, in this invention, after said development step and prior to the etching step, the positive working photo resist still remained at the unexposed area is subjected to exposure to an actinic radiation, preferably UV rays having wave length of 200 to 500nm, thereby attaining the object of preventing the formation of slender line due to side-etching and obtaining fine circuit pattern.

Even if such re-exposure step is adopted, the remained resist is insoluble in an acidic solution and therefore, said resist can discharge its duties as an etching resist. Furthermore, photosensitive groups contained in the resin are affected by said re-exposure, resulting the resin with excellent adhesion to the base plate and with excellent acid resistance, which in turn contributes to an effective protection of possible side-etching and formation of slender line.

Thus, in the present invention, a very simple operation is only added, between the development step and wet etching step, to the conventional method for the preparation of a printed circuit board, thereby preventing surely and effectively the formation of slender line and obtaining very fine circuit pattern.

In a semi-conductor area, several attempts have been made on the use of such re-exposure technique. That is, in Japanese Patent Publication (unexamined) 301521/88 and ibid 105537/89, has been stated a method wherein a positive resist pattern is first made on a semi-conductor base plate by using an exposure and development means, thus formed resist is again exposed to UV rays and then heat-treated to form tapered resist pattern which is suitable for the formation of fine pattern by a dry etching. In Japanese Patent Publication (unexamined) 301521/88, is like-wise disclosed a method wherein the resist pattern obtained by development is exposed to UV rays to effect photolysis of photosensitive groups and improve thermal flowability of the resist and thus treated resist is heated to give tapered resist pattern which is suitable for dry etching. Also, in Japanese Patent Publication (unexamined) 105537/89, the resist pattern obtained by development is subjected to deep UV irradiation under heating, thereby effecting exaggerated hardening at the surface area of the resist and forming desired tapered resist pattern. All of the abovementioned techniques concern the formation of tapered resist pattern suitable for dry etching and heat treatment is always required after UV rays exposure (for the control of thermal flowability of the resist).

Whereas, in the present invention, such re-flowing step is not required after UV exposure and wet etching is adopted in place of the abovementioned dry etching.

UV exposure is carried out for the purpose of improving adhesion properties to the base plate and acid resistance of the resist and side-etching at the time of wet etching is effectively controlled therewith. Therefore, the present technique should be strictly distinguished from the abovementioned conventional techniques used in the semiconductor area.

The invention shall be more minutely stated in the following Examples.

Unless otherwise being stated, all parts and percentages are by weight.

Manufacturing Example 1

Preparation of acrylic resin varnish

Into a 1 liter glass flask fitted with a stirrer, a condenser, a thermometer and an air inlet tube, were placed 207.2 parts of phthalic anhydride, 501.2 parts of Placcel FM-2 (2:1 mol addition product of ε-caprolactone and 2-hydroxyethyl methacrylate, Trademark, Daisel Chem. Co.) and 500ppm of the total charged materials of hydroquinone monomethyl ether. While introducing air through the air inlet tube, the content was reacted at 150°C (inner temperature) for 1 hour under stirring. After completion of the reaction, the mixture was allowed to cool to a room temperature, and filtered to obtain a reactive acrylic monomer, having an acid value of 114.

The reaction yield calculated from the abovementioned acid value was 97%.

Next, into a 1 liter glass vessel fitted with a stirrer, a condenser, a thermometer, a dropping funnel and a nitrogen gas inlet tube, were placed 300 parts of ethyleneglycol monobutyl ether and while maintaining at the inner temperature at 120°C and continuing stirring, a mixture of 140 parts of the abovementioned acrylic monomer, 130 parts of methyl methacrylate, 130 parts of n-butyl acrylate and 10 parts of t-butyl peroxy 2-ethyl hexanoate (polymerization initiator) was drop-wise added in 3 hours. Thereafter, the mixture was maintained at 120°C for additional 2 hours to obtain an acrylic resin composition. Thus formed resin had a weight average molecular weight of 30,000 and an acid value of 39.9.

Manufacturing Example 2 : Preparation of positive working photosensitive resin

Into a 1 liter glass made reaction flask fitted with a stirrer, a condenser and a thermometer, were placed 100 parts of polyethylene glycol diglycidyl ether (epoxy equivalent 192.5), 71.8 parts of salicylic acid and 28 parts of ethyleneglycol monoethyl ether acetate and heated to 120°C. 0.5 part of benzyl dimethyl amine catalyst was then added and the mixture was reacted for 6 hours to obtain a reaction mixture having an acid value of 5.6 (Reaction yield 96.2%). Next, the mixture was allowed to cool to 10°C and added with 105 parts of 1,2-naphthoquinone diazide-5-sulfonyl chloride and 160 parts of dioxane to obtain a solution. 43.5 parts of triethylamine were dropwise added thereto and thus obtained :mixture was stirred for 2 hours. The reaction mixture was then poured into a quantity of 2% aqueous HCl solution to precipitate the reaction product. The precipitated were filtered, washed with water and dried in vacuum at 40°C for hours to obtain a positive working photosensitive resin. The reaction yield was 93%.

Manufacturing Example 3 : Preparation of a photosensitive material

An electrodeposition bath liquid was prepared by adding a solution of 20 parts of the positive working photosensitive resin obtained in Manufacturing Example 2 in 20 parts of propylene glycol monomethyl ether to 140 parts of the acrylic resin varnish obtained in Manufacturing Example 1, and further combining with 4.6 parts of triethylamine and 815.4 parts of deionized water.

A printed circuit board base plate composed of an insulating base plate having 0.3mm through-holes previously electrolessly plated and then electroplated with copper in 50μm thickness was dipped into the abovementioned electrodeposition bath liquid.

After connecting the base plate to an anode and the metallic wall of the electrodeposition bath to a cathode, a 50mA/dm² direct current was impressed at 25°C for 2 minutes and thus treated plate was then washed with water and dried in an air oven maintained at 100°C for 5 minutes to obtain a photosensitive material having a positive working photosensitive resin layer of 7μm thickness.

Manufacturing Example 4 : Preparation of positive working photosensitive resin

Into a 500ml separable flask, were added 250 parts of pyridine and 117 parts of fluorenone oxime and the mixture was cooled to less than 10°C. To this, 120 parts of p-styrene sulfonyl chloride were drop-wise added and the combined was reacted at less than 20°C for 3 hours. The content was then drop-wise added to 2,500 parts of 5% HCl, ice-cooled solution, and the mixture was extracted with 500 parts of chloroform. The chloroform solvent was then removed off under reduced pressure from the extract to obtain fluorenone oxime p-styrene sulfonate. This was identified by IR and NMR spectrum.

Manufacturing Example 5 : Preparation of acrylic resin varnish

Into a 1 liter separable flask, were placed 200 parts of ethyleneglycol monobutyl ether and heated to 120°C. To this, a mixture of 140 parts of ethyl methacrylate, 60 parts of n-butyl methacrylate, 50 parts of fluorenone oxime p-styrene sulfonate obtained in Manufacturing Example 4 and 8 parts of azobis-isobutyronitrile was drop-wise added in 3 hours and after elapsing 30 minutes from the end of said addition, a mixture of 30 parts of ethyleneglycol monobutyl ether and 1 part of azobis-isobutyronitrile was drop-wise added in 30 minutes and the mixture was reacted at 120°C for 1 hour to obtain an acrylic resin varnish having a solid content of 51.1%. Molecular weight of thus formed iminosulfonate group bearing acrylic resin was about 30,000.

Manufacturing Example 6 : Preparation of a photosensitive material

An electrodeposition bath liquid was prepared by adding 4 parts of triethylamine to 100 parts of the iminosulfonate group bearing acrylic resin obtained in Manufacturing Example 5 and adding 280 parts of deionized water portion to portion, under stirring, to the abovementioned mixture.

A printed circuit board base plate composed of an insulating base plate having 0.3mm through-holes previously electrolessly plated and then electroplated with copper in $50\mu m$ thickness was dipped into the abovementioned electrodeposition bath liquid. After connecting the base plate to an anode and the metallic wall of the electrodeposition bath to a cathode, a $50mA/dm^2$ direct current was impressed at 25°C for 2 minutes and thus treated plate was then washed with water and dried in an air oven maintained at 100°C for 5 minutes to obtain a photosensitive material having a positive working photosensitive resin layer of $7\mu m$ thickness.

Example 1

Fig. 1 shows the cross-section of the photosensitive material used in the invention, each in different stage of the present method (excepting omitting through-holes). On the positive working photosensitive material (Fig. 1 (a)) obtained in Manufacturing Example 3, a positive mask having a circuit pattern with $130\mu m$ width line was placed and the photosensitive material was exposed through said mask to 200~ 500nm UV rays be using a high pressure mercury lamp. Thus exposed material was then developed with an aqueous 1% sodium metasilicate solution to obtain a resist pattern (4) of Fig.1 (b).

The resist was again exposed to 200~500nm rays by using a high pressure mercury lamp to obtain an exposed resist pattern (5), in which the remained photosensitive groups had been photolytically decomposed to acidic groups, of Fig. 1 (c). Next, a wet-etching using a cupric chloride solution was carried out to obtain a circuit pattern (6) with the least side-etching as shown in Fig. 1 (d).

Finally, the remaining resist (5) was removed off by using an aqueous 3%KOH solution at 55°C to obtain the desired printed circuit board (not shown).

Thus obtained circuit line had the top width of $110\mu m$ and the bottom width of $130\mu m$.

Example 2

The similar experiments as stated in Example 1 were repeated by using the photosensitive material obtained in Manufacturing Example 6. However, in this example, development was carried out with an aqueous 2% tetramethylammonium hydroxide solution and at the final stage, the remained resist was removed off by using an aqueous 5% sodium hydroxide solution.

Thus obtained circuit line had the top width of $105\mu m$ and the bottom width of $130\mu m$.

Comparative Example 1

As shown in Fig. 2, the similar experiments as stated in Example 1 were carried out, excepting omitting the re-exposure of the developed resist (Fig.1 (c)). Thus obtained circuit line had the top width of $90\mu m$ and the bottom width of $130\mu m$.

Comparative Example 2

Using the photosensitive material as used in Example 2, the same procedures as shown in said Example 2 were repeated, excepting omitting the re-exposure step.

Thus obtained circuit line had the top width of 85μm and the bottom width of 130μm.

**Claims**

1. In a method for forming a resist pattern comprising exposing a photosensitive material which is a laminate of an insulating base plate, an electric conductive coating and a positive working photo resist coating, through a positive mask of circuit pattern placed on said photo resist, to an actinic radiation, developing the photo resist with an aqueous alkaline solution, thereby removing the exposed area and forming an etching resist, subjecting said resist to an etching with an acidic etching solution to remove the exposed conductive coating and finally removing the resist still remained on the unexposed area of the photosensitive material, characterized in that after said development and prior to the etching operation, the unexposed resist is further exposed to an actinic radiation.

# Fig. 1

(a)

(b)

(c)

(d)

# F i g . 2

(a)

-13
-12
-11

(b)

-14
-12
-11

(c)

-14
-16
-11